# EUROPÄISCHE PATENTSCHRIFT

(11) **EP 3 447 865 B1**
(45) Veröffentlichungstag und Bekanntmachung des Hinweises auf die Patenterteilung: **05.10.2022**
(21) Anmeldenummer: 17187490.2
(22) Anmeldetag: 23.08.2017
(51) Int. Cl.: H02G 1/12

(54) **VERFAHREN ZUM ENTFERNEN EINES TEILS EINER SCHIRMFOLIE EINES MANTELLEITUNGSKABELS UND FOLIENENTFERNUNGSVORRICHTUNG ZUM ENTFERNEN EINES TEILS EINER SCHIRMFOLIE EINES MANTELLEITUNGSKABELS AN EINER SOLLBRUCHSTELLE VON DEM MANTELLEITUNGSKABEL**
METHOD FOR REMOVING PART OF A SCREEN FILM OF A SHEATH CONDUCTOR CABLE AND FILM REMOVAL DEVICE FOR REMOVING PART OF A SCREEN FILM OF A SHEATH CONDUCTOR CABLE AT A PREDETERMINED BREAKING POINT OF THE SHEATH CONDUCTOR CABLE
PROCÉDÉ D'ENLÈVEMENT D'UNE PARTIE D'UNE FEUILLE ÉCRAN D'UN HABILLAGE DE CÂBLE DE LIGNE ET DISPOSITIF D'ENLÈVEMENT DES FEUILLES PERMETTANT L'ENLÈVEMENT D'UNE PARTIE D'UNE FEUILLE ÉCRAN D'UN HABILLAGE DE CÂBLE DE LIGNE À UN POINT DE RUPTURE DE L'HABILLAGE DE CÂBLE DE LIGNE

(43) Veröffentlichungstag der Anmeldung: 27.02.2019
(73) Patentinhaber: KOMAX HOLDING AG, 6036 Dierikon (CH)
(72) Erfinder: SILBERBAUER, Günther, 94535 Eging am See (DE)
(74) Vertreter: Inventio AG

(56) Entgegenhaltungen:
- WO-A1-2011/054697
- WO-A1-2015/125129
- DE-U1-202006 003 872
- US-A- 5 787 574
- US-A1- 2008 098 598
- US-A1- 2015 162 729
- US-B1- 6 631 554

## Beschreibung

Die vorliegende Erfindung betrifft ein Verfahren zum Entfernen eines Teils einer Schirmfolie eines Mantelleitungskabels und eine Folienentfernungsvorrichtung zum Entfernen eines Teils einer Schirmfolie eines Mantelleitungskabels an einer Sollbruchstelle von dem Mantelleitungskabel.

Die Schirmfolie eines Mantelleitungskabels, die innenliegende Leitungen vor elektrischen Wechselfeldern schützt, muss oftmals sauber, d.h. ohne Fähnchenbildung, von dem Mantelleitungskabel abgetrennt und entfernt werden.

Die JP 3 469 398 B2 beschreibt eine Vorrichtung, welche die Schirmfolie durch den Außenmantel des Mantelleitungskabels hindurch mit Nadeln perforiert. Gleichzeitig wird der Außenmantel an einer anderen Stelle getrennt. Der Außenmantel und die Schirmfolie werden nach der Bearbeitung zusammen gerade vom restlichen Mantelleitungskabel gezogen. Hierbei reißt die Schirmfolie an der Perforation. Nachteilig hieran ist, dass, insbesondere wenn die Schirmfolie z.B. aus Kunststoff mit aufgedampfter Metallschicht besteht, eine Fähnchenbildung auftreten kann.

Die WO 2015/125 129 A beschreibt eine Methode zum Entfernen einer Schirmfolie. Wenn die Schirmfolie aus einem metallbedampften Kunststoff besteht, so kann aufgrund der Duktilität der Schirmfolie die erfolgreiche Bildung eines Scherbruchs oder Scherrisses nicht sichergestellt sein bzw. werden. Somit ist eine Fähnchenbildung nicht sicher ausgeschlossen.

Die WO 2014/001 716 A1 offenbart eine Vorrichtung, bei der die Schirmfolie mittels Laserstrahl über den gesamten Umfang getrennt wird, während die Isolationsschicht der inneren Kabel bzw. Leitungen durch den Laserstrahl nicht beschädigt wird. Ein Nachteil hiervon ist, dass das Trennen bzw. Entfernen der Schirmfolie sehr lange dauert. Weiterer Stand der Technik ist aus der US 6,631,554 B1, der US 8,302,295 B2, der WO 2008/084 216 A1, der EP 2 828 030 A1, der US 7,947,921 B2, der US5787574, der US6631554, der US 6,509,547 B1 und der EP 1 641 572 B1 bekannt.

Es kann unter anderem ein Bedarf an einem Verfahren zum Entfernen eines Teils einer Schirmfolie eines Mantelleitungskabels bzw. an einer Folienentfernungsvorrichtung zum Entfernen eines Teils einer Schirmfolie eines Mantelleitungskabels an einer Sollbruchstelle von dem Mantelleitungskabel bestehen, mittels dem bzw. der die Schirmfolie technisch einfach ohne Fähnchenbildung schnell getrennt bzw. entfernt werden kann.

Einem solchen Bedarf kann durch ein Verfahren zum Entfernen eines Teils einer Schirmfolie eines Mantelleitungskabels bzw. eine Folienentfernungsvorrichtung zum Entfernen eines Teils einer Schirmfolie eines Mantelleitungskabels an einer Sollbruchstelle von dem Mantelleitungskabel gemäß den unabhängigen Ansprüchen entsprochen werden. Vorteilhafte Ausführungsformen sind in den abhängigen Ansprüchen definiert.

Gemäß einem ersten Aspekt der Erfindung wird ein Verfahren zum Entfernen eines Teils einer Schirmfolie eines Mantelleitungskabels vorgeschlagen, wobei das Mantelleitungskabels einen ersten Teil und einen zweiten Teil umfasst und wobei der zweite Teil ergriffen ist, wobei das Verfahren folgende Schritte umfasst: Bereitstellen des Mantelleitungskabels mit der Schirmfolie, wobei die Schirmfolie eine im Wesentlichen entlang eines Umfangs der Schirmfolie verlaufende Sollbruchstelle aufweist; Biegen eines Teilbereichs des Mantelleitungskabels mit der Schirmfolie in eine erste Richtung zum Erzeugen einer derartigen Reißspannung an der Sollbruchstelle auf einem Teil des Umfangs der Schirmfolie, dass die Schirmfolie an der Sollbruchstelle auf einem Teil des Umfangs der Schirmfolie reißt; Bewegen eines ersten Teils des Mantelleitungskabels in einer im Wesentlichen ellipsenförmigen, insbesondere kreisförmigen, Bewegung zum Erzeugen einer Reißspannung über im Wesentlichen den gesamten Umfang der Schirmfolie, so dass die Schirmfolie an der Sollbruchstelle über den gesamten Umfang der Schirmfolie reißt; und Entfernen des von dem Mantelleitungskabel getrennten Teils der Schirmfolie von dem Mantelleitungskabel. Ein Vorteil hiervon ist, dass eine Fähnchenbildung der Schirmfolie sicher vermieden wird. D.h., es ist sichergestellt, dass die Schirmfolie ausschließlich entlang der Sollbruchstelle reißt und sich an keiner anderen Stelle ein Riss bildet. Zudem kann das Verfahren sehr schnell durchgeführt werden, da die elliptische Bewegung sehr schnell ausgeführt werden kann. Darüber hinaus ist das Verfahren technisch besonders einfach.

Gemäß einem zweiten Aspekt der Erfindung wird eine Folienentfernungsvorrichtung zum Entfernen eines Teils einer Schirmfolie eines Mantelleitungskabels an einer Sollbruchstelle von dem Mantelleitungskabel vorgeschlagen, wobei die Entfernungsvorrichtung folgendes aufweist: - einen Biegegreifer zum Greifen eines ersten Teils des Mantelleitungskabels und zum Halten des ergriffenen ersten Teils des Mantelleitungskabels derart, dass das Mantelleitungskabel sich zumindest teilweise in einem gebogenen Zustand befindet, so dass eine derartige Reißspannung an der Sollbruchstelle auf einem Teil des Umfangs der Schirmfolie erzeugt wird, dass die Schirmfolie an der Sollbruchstelle auf einem Teil des Umfangs der Schirmfolie reißt; und - eine Drehvorrichtung zum Bewegen des Biegegreifers derart, dass der erste Teil des Mantelleitungskabels entlang einer elliptischen, insbesondere kreisförmigen, Bahn zum Erzeugen einer Reißspannung über im Wesentlichen den gesamten Umfang der Schirmfolie bewegt wird, so dass die Schirmfolie an der Sollbruchstelle über den gesamten Umfang der Schirmfolie reißt.

Vorteilhaft hieran ist, dass bei dem Trennen der Schirmfolie von dem Mantelleitungskabel mittels der Folienentfernungsvorrichtung eine Fähnchenbildung sicher vermieden ist. D.h., es ist sichergestellt, dass die Schirmfolie ausschließlich entlang der Sollbruchstelle reißt und sich an keiner anderen Stelle ein Riss bildet. Darüber hinaus ist es mit der Folienentfernungsvorrichtung möglich, die Schirmfolie sehr schnell von dem Mantelleitungskabel zu trennen bzw. zu entfernen. Auch ist die Folienentfernungsvorrichtung besonders kostengünstig ausgebildet.

Mögliche Merkmale und Vorteile von Ausführungsformen der Erfindung können unter Anderem und ohne die Erfindung einzuschränken als auf nachfolgend beschriebenen Ideen und Erkenntnissen beruhend angesehen werden.

Gemäß einer Ausführungsform wird das Bewegen des ersten Teils des Mantelleitungskabels in einer elliptischen, insbesondere kreisförmigen, Bewegung in einem Drehsinn ausgeführt, die entgegengesetzt zu einer Wickelrichtung der Schirmfolie entlang eines Umfangs des Mantelleitungskabels ist. Ein Vorteil hiervon ist, dass, insbesondere wenn der innere Teil der Schirmfolie im Überlappungsbereich eine schlechtere Perforation als der äußere Teil der Schirmfolie im Überlappungsbereich aufweist, der Riss an der Sollbruchstelle zuverlässig in den inneren Teil der Schirmfolie geleitet wird. Folglich wird die Fähnchenbildung, auch im Überlappungsbereich der Schirmfolie, noch sicherer verhindert.

Gemäß einer Ausführungsform wird vor dem Schritt des Bewegens des ersten Teils des Mantelleitungskabels in einer elliptischen Bewegung die Schirmfolie in die Längsrichtung des Mantelleitungskabels vorgespannt. Hierdurch wird besonders sichergestellt, dass die Schirmfolie entlang der Sollbruchstelle reißt. Zudem kann der Biegewinkel bzw. Auslenkwinkel, mit bzw. in dem das Mantelleitungskabel gebogen wird, gering bzw. klein sein. Somit lässt sich das Verfahren auch bei besonders biegeempfindlichen Mantelleitungskabeln durchführen, ohne dass es zu unbeabsichtigten Beschädigungen des Mantelleitungskabels kommt.

Gemäß einer Ausführungsform wird eine Länge eines Biegebereichs, in dem das Mantelleitungskabel durch die elliptische Bewegung des ersten Teils des Mantelleitungskabels gebogen wird, und/oder ein Biegewinkel, in dem das Mantelleitungskabel durch die elliptische Bewegung des ersten Teils des Mantelleitungskabels gebogen wird, auf die Eigenschaften des Mantelleitungskabels angepasst. Hierdurch wird das Mantelleitungskabel besonders schonend während des Entfernens eines Teils der Schirmfolie behandelt. Somit werden unbeabsichtigte Beschädigungen des Mantelleitungskabels noch sicherer verhindert. Die Eigenschaften des Mantelleitungskabels können z.B. eine Biegesteifigkeit des Mantelleitungskabels umfassen.

Gemäß einer Ausführungsform umfasst das Verfahren ferner folgenden Schritt: Lösen der von dem Mantelleitungskabel an der Sollbruchstelle abgetrennten Schirmfolie von einem Biegegreifer, der den von dem Mantelleitungskabel abgetrennten Teil der Schirmfolie hält, mittels Druckluft und/oder Absaugen der abgetrennten Schirmfolie. Vorteilhaft hieran ist, dass der abgetrennte Teil der Schirmfolie technisch einfach von dem Biegegreifer gelöst und/oder von dem Mantelleitungskabel entfernt wird.

Gemäß einer Ausführungsform wird ein zweiter Teil des Mantelleitungskabels derart ergriffen, dass sich die Sollbruchstelle zwischen dem ersten Teil des Mantelleitungskabels und dem zweiten Teil des Mantelleitungskabels befindet. Hierdurch kann die Länge, in der das Mantelleitungskabel gebogen wird, verringert werden. Somit wird das Mantelleitungskabel noch zuverlässiger vor unbeabsichtigten Beschädigungen geschützt. Zudem wird hierdurch bei gleichbleibender Zug-/Reißspannung die zum Zerreißen der Schirmfolie in bzw. entlang der Sollbruchstelle benötigte Winkelauslenkung bzw. Biegung des Mantelleitungskabels verringert.

Gemäß einer Ausführungsform wird der erste Teil des Mantelleitungskabels mittels einer kardanischen Aufhängung in einer ellipsenförmigen Bewegung bewegt. Hierdurch kann der erste Teil des Mantelleitungskabels technisch besonders einfach gedreht werden.

Gemäß einer Ausführungsform wird der erste Teil des Mantelleitungskabels mittels der kardanischen Aufhängung in einer ellipsenförmigen Bewegung derart bewegt, dass sich auf einer Ebene, in der die Sollbruchstelle der Schirmfolie verläuft, der Drehpunkt der kardanischen Aufhängung befindet. Hierdurch kann das Mantelleitungskabel an der Sollbruchstelle besonders zuverlässig reißen, während gleichzeitig der Teil des Mantelleitungskabels, der in einer elliptischen Form bewegt wird, möglichst wenig bewegt werden. Folglich wird das Mantelleitungskabel besonders zuverlässig vor ungezielten Beschädigungen geschützt.

Gemäß einer Ausführungsform umfasst das Verfahren ferner folgenden Schritt: Erzeugen der Sollbruchstelle der Schirmfolie durch Loch- und/oder Schlitzperforieren der Schirmfolie entlang des Umfangs der Schirmfolie. Ein Vorteil hiervon ist, dass die Sollbruchstelle technisch einfach und besonders schnell hergestellt wird.

Gemäß einer Ausführungsform ist in einem Überlappungsbereich der Schirmfolie, in dem die Schirmfolie entlang eines Umfangs des Mantelleitungskabels überlappend angeordnet ist, ein in Radialrichtung des Mantelleitungskabels äußerer Teil der Schirmfolie an der Sollbruchstelle schlitzperforiert wird und ein in Radialrichtung des Mantelleitungskabels innerer Teil der Schirmfolie an der Sollbruchstelle lochperforiert wird. Vorteilhaft hieran ist, dass die Sollbruchstelle technisch einfach hergestellt wird, und die Sollbruchstelle besonders zuverlässig ohne Fähnchenbildung reißt.

Gemäß einer Ausführungsform umfasst die Folienentfernungsvorrichtung ferner einen Zusatzgreifer zum Ergreifen eines zweiten Teils des Mantelleitungskabels derart, dass sich die Sollbruchstelle zwischen dem Zusatzgreifer und dem Biegegreifer befindet. Hierdurch kann die Länge, in der das Mantelleitungskabel gebogen wird, verringert werden. Somit wird das Mantelleitungskabel noch zuverlässiger vor unbeabsichtigten Beschädigungen geschützt. Zudem kann hierdurch bei gleichbleibender Zug-/Reißspannung die zum Zerreißen der Schirmfolie in bzw. entlang der Sollbruchstelle benötigte Winkelauslenkung des Mantelleitungskabels verringert werden.

Gemäß einer Ausführungsform umfasst die Folienentfernungsvorrichtung ferner eine oder mehrere Ausblasöffnungen in dem Biegegreifer zum Ausblasen eines Fluids zum Lösen der Schirmfolie von dem Biegegreifer und/oder eine Absaugvorrichtung zum Absaugen der von dem Mantelleitungskabel getrennten Schirmfolie. Vorteilhaft hieran ist, dass der abgetrennte Teil der Schirmfolie technisch einfach von dem Biegegreifer gelöst und/oder von dem Mantelleitungskabel entfernt werden kann.

Gemäß einer Ausführungsform der Folienentfernungsvorrichtung weist der Biegegreifer eine sich von der Sollbruchstelle weg verbreiternde kegelstumpfförmige Aussparung, insbesondere eine kegelstumpfartige Aussparung mit einem Öffnungswinkel der Aussparung von kleiner gleich ca. 4°, auf. Ein Vorteil hiervon ist, dass der Biegegreifer das Mantelleitungskabel bzw. eine Spitze des Mantelleitungskabels besonders sicher halten kann.

Gemäß einer Ausführungsform ist die Drehvorrichtung derart ausgebildet, dass ein Drehsinn des ersten Teils des Mantelleitungskabels bei dem Bewegen des ersten Teils des Mantelleitungskabels entlang einer elliptischen, insbesondere kreisförmigen, Bahn, auf eine Wickelrichtung der Schirmfolie entlang eines Umfangs des Mantelleitungskabels, abstimmbar ist. Vorteilhaft hieran ist, dass, insbesondere wenn der innere Teil der Schirmfolie im Überlappungsbereich eine schlechtere Perforation als der äußere Teil der Schirmfolie im Überlappungsbereich, der Riss an der Sollbruchstelle zuverlässig in den inneren Teil der Schirmfolie geleitet werden kann. Folglich ist die Fähnchenbildung, auch im Überlappungsbereich der Schirmfolie, noch sicherer verhindert.

Die ellipsenförmige Bewegung kann auch eine Bewegung sein, die nur annähernd einer Ellipse entspricht. Insbesondere kann die eine ellipsenförmige Bewegung auch eine Bewegung sein, die keine zwei Brennpunkte aufweist, wobei der Verlauf der Bewegung entlang der Bewegungsbahn jedoch stetig ist, d.h. insbesondere keine abrupten Sprünge macht. Die ellipsenförmige Bewegung kann auch eine Art Taumelbewegung sein.

Es wird daraufhingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
- Fig. 1 zeigt: eine perspektivische Ansicht einer ersten Ausführungsform der erfindungsgemäßen Folienentfernungsvorrichtung;
- Fig. 2 zeigt: eine Detailansicht eines Mantelleitungskabels mit einer Schirmfolie, die eine Sollbruchstelle aufweist;
- Fig. 3a zeigt: eine Querschnittsansicht eines weiteren Mantelleitungskabels;
- Fig. 3b zeigt: eine Querschnittsansicht des Mantelleitungskabels aus Fig. 2;
- Fig. 4 zeigt: eine Querschnittsansicht der Folienentfernungsvorrichtung aus Fig. 1;
- Fig. 5a zeigt: eine Seitenansicht des Mantelleitungskabels aus Fig. 2 vor einem Biegen;
- Fig. 5b zeigt: eine Seitenansicht des Mantelleitungskabels aus Fig. 5a während des Biegens vor dem Reißen der Schirmfolie an einer Sollbruchstelle;
- Fig. 5c zeigt: eine Seitenansicht des Mantelleitungskabels aus Fig. 5a bzw. Fig. 5b während des Biegens nach dem Reißen der Schirmfolie über einen Teil des Umfangs der Schirmfolie;
- Fig. 6a zeigt: die Folienentfernungsvorrichtung aus Fig. 1 mit dem Biegegreifer in einer Grundposition ohne ein Mantelleitungskabel;
- Fig. 6b zeigt: die Folienentfernungsvorrichtung aus Fig. 6a, nach dem Drehen des Biegegreifers aus der Grundposition;
- Fig. 6c zeigt: die Folienentfernungsvorrichtung aus Fig. 6a bzw. Fig. 6b nach dem Drehen des Biegegreifers;
- Fig. 6d zeigt: die Folienentfernungsvorrichtung aus Fig. 6a bzw. Fig. 6b bzw. Fig. 6c nach einem weiteren Drehen des Biegegreifers; und
- Fig. 6e zeigt: die Folienentfernungsvorrichtung aus Fig. 6a bzw. Fig. 6b bzw. Fig. 6c bzw. Fig. 6d nach einem weiteren Drehen des Biegegreifers.

Die Figuren sind lediglich schematisch und nicht maßstabsgetreu. Gleiche Bezugszeichen bezeichnen in den verschiedenen Figuren gleiche oder gleichwirkende Merkmale

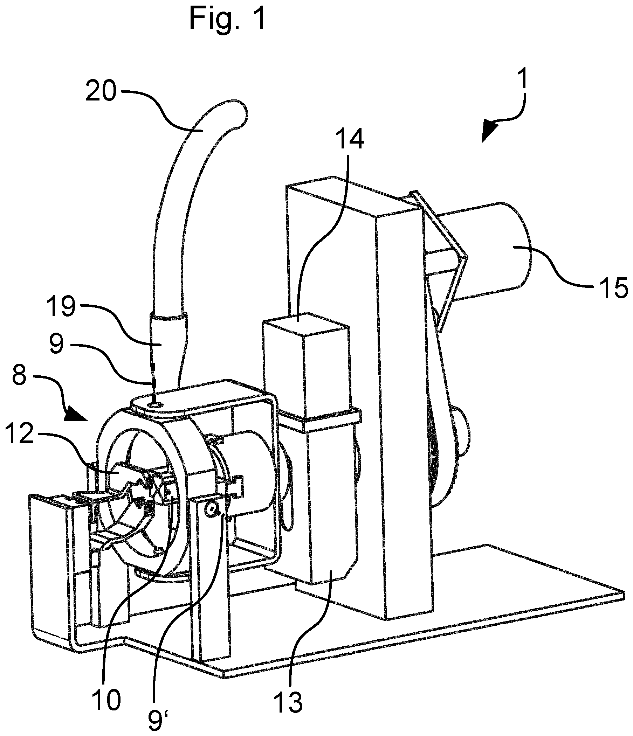

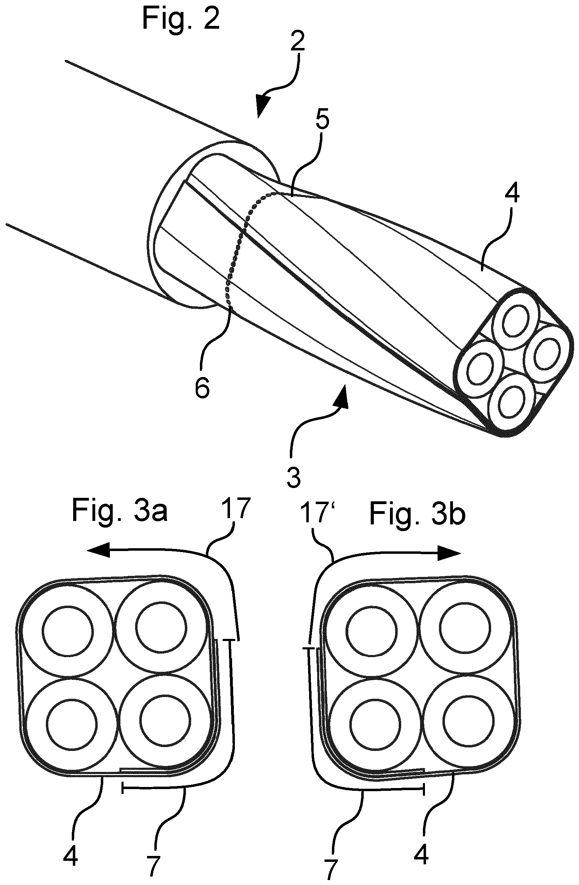

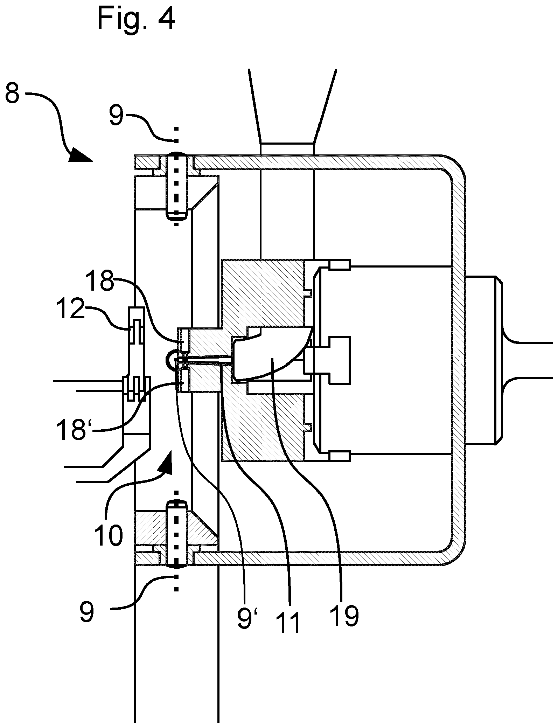

Fig. 1 zeigt eine perspektivische Ansicht einer ersten Ausführungsform der erfindungsgemäßen Folienentfernungsvorrichtung 1. Fig. 2 zeigt eine Detailansicht eines Mantelleitungskabels 2 mit einer Schirmfolie 4, die eine Sollbruchstelle 5 aufweist. Fig. 3a zeigt eine Querschnittsansicht eines weiteren Mantelleitungskabels 2. Fig. 3b zeigt eine Querschnittsansicht des Mantelleitungskabels 2 aus Fig. 2. Fig. 4 zeigt eine Querschnittsansicht der Folienentfernungsvorrichtung 1 aus Fig. 1.

Die Folienentfernungsvorrichtung 1 ist zum Entfernen eines Teils einer Schirmfolie 4 eines Mantelleitungskabels 2 ausgebildet. Der Teil der Schirmfolie 4 wird hierzu von dem übrigen Mantelleitungskabel 2 bzw. dem übrigen Teil der Schirmfolie 4, der mit dem Mantelleitungskabel 2 verbunden ist und bleibt, abgetrennt. Die Schirmfolie 4 umfasst Metall zum Abschirmen elektromagnetischer Strahlung in und/oder aus den Leitern des Mantelleitungskabels 2, die innerhalb der Schirmfolie 4 verlaufen. Die Schirmfolie 4 umgreift bzw. umläuft sozusagen die Leiter des Mantelleitungskabels 2. Die Schirmfolie 4 ist sehr dünn ausgebildet. Insbesondere kann die Schirmfolie einen Kunststoff mit aufgedampfter Metallschicht umfassen bzw. aus einem Kunststoff mit aufgedampfter Metallschicht bestehen.

An einer Stelle bzw. in einem Bereich, der im Wesentlichen entlang des Umfangs der Schirmfolie 4 verläuft, wird eine Sollbruchstelle 5 ausgebildet. Die Sollbruchstelle 5 kann z.B. eine Schlitzperforation und/oder eine Lochperforation 6 aufweisen. Die Sollbruchstelle 5 kann mittels eines Laserstrahls und/oder mittels eines mechanischen Schneidwerkzeugs ausgebildet werden. Die Umfangsrichtung der Schirmfolie 4 verläuft in Fig. 3a bzw. Fig. 3b in der Zeichenebene um die vier Leiter herum.

Wie in Fig. 2 dargestellt ist die äußere Isolierung bzw. Schicht des Mantelleitungskabels 2, die in radialer Richtung außerhalb der Schirmfolie 4 angeordnet ist, teilweise entfernt.

Die Folienentfernungsvorrichtung 1 umfasst einen Biegegreifer 10 zum Greifen bzw. Halten des Mantelleitungskabels 2. Der Biegegreifer 10 umfasst vier Greifbacken. Die Greifbacken können senkrecht zu einer Längsrichtung des Mantelleitungskabels 2, die die in Fig. 4 von links nach rechts verläuft, aufeinander zu bewegt werden zum Ergreifen des Mantelleitungskabels 2. Die Greifbacken können senkrecht zu der Längsrichtung des Mantelleitungskabels 2 voneinander weg bewegt werden zum Loslassen des Mantelleitungskabels 2.

Der Biegegreifer 10 greift bzw. hält den Teil der Schirmfolie 4, der von dem Mantelleitungskabel 2 entfernt werden soll.

Die Greifbacken können zusammen eine Greiffläche 11 aufweisen, die in einer Richtung, die in Fig. 4 von links nach rechts verläuft, einer kegelstumpfförmigen Aussparung entspricht. Der Winkel des Kegelstumpfs der kegelstumpfförmigen Aussparung kann kleiner gleich ca. 4° betragen, z.B. ca. 2° oder ca. 3°. Die Greiffläche 11 des Biegegreifers 10 kann eine raue Oberfläche aufweisen. Die Greifbacken können zueinander identisch bzw. gleichartig ausgebildet sein.

Der Biegegreifer 10 ist mittels einer kardanischen Aufhängung 8 befestigt. Die Achse 9 der kardanischen Aufhängung 8 verläuft in Fig. 4 von oben nach unten. Die weitere zu der Achse 9 senkrechte Achse 9' der kardanischen Aufhängung 8 verläuft in Fig. 4 aus der Zeichenebene heraus. Der Schnittpunkt der beiden Achsen 9, 9' der kardanischen Aufhängung 8 ist die Stelle, an der die Sollbruchstelle 5 der Schirmfolie 4 angeordnet wird. Anders ausgedrückt, wird das Mantelleitungskabel 2 derart in der Folienentfernungsvorrichtung 1 angeordnet, dass sich der Drehpunkt der kardanischen Aufhängung 8 des Biegegreifers 10 auf einer Ebene befindet, in der die Sollbruchstelle 5 liegt bzw. die von der Sollbruchstelle 5 aufgespannt wird.

Der Biegegreifer 10 bzw. die Greifbacken können einen (geringsten) Abstand von weniger als ca. 1 mm von der Sollbruchstelle 5 (entlang der Längsrichtung des Mantelleitungskabels 2) aufweisen.

Der Biegegreifer 10 ist über eine weitere kardanische Aufhängung 8 und/oder über ein Kugelgelenk mit einer Exzentereinrichtung 13 verbunden. Ein Exzenteraktuator 14 kann ein Element der Exzentereinrichtung 13 derart bewegen, dass sich der Biegegreifer 10, z.B. während er das Mantelleitungskabel 2 hält bzw. greift, um die Achse 9' dreht (bzw. abkippt) und folglich das Mantelleitungskabel 2 gebogen wird.

Die Folienentfernungsvorrichtung 1 kann optional einen Zusatzgreifer 12 aufweisen, der einen Teil des Mantelleitungskabels 2 greift bzw. hält. Der Zusatzgreifer 12 ist derart beabstandet zu dem Biegegreifer 10 angeordnet, dass die Sollbruchstelle 5 zwischen dem von dem Biegegreifer 10 ergriffenen ersten Teil des Mantelleitungskabels 2 und dem von dem Zusatzgreifer 12 ergriffenen zweiten Teil des Mantelleitungskabels 2 anordenbar ist. Durch den Zusatzgreifer 12 kann ein kleiner Teil bzw. ein geringer Längenabschnitt des Mantelleitungskabels 2 mittels des Biegegreifers 10 gebogen werden. Der erste Teil des Mantelleitungskabels 2 kann die Mantelleitungskabelspitze 3 oder ein Teil der Mantelleitungskabelspitze 3 sein. Der erste Teil des Mantelleitungskabels 2 kann zusätzlich einen Teil des Mantelleitungskabels 2 umfassen, der unmittelbar bzw. direkt an die Mantelleitungskabelspitze 3 angrenzt und dem Biegegreifer 10 abgewandt ist.

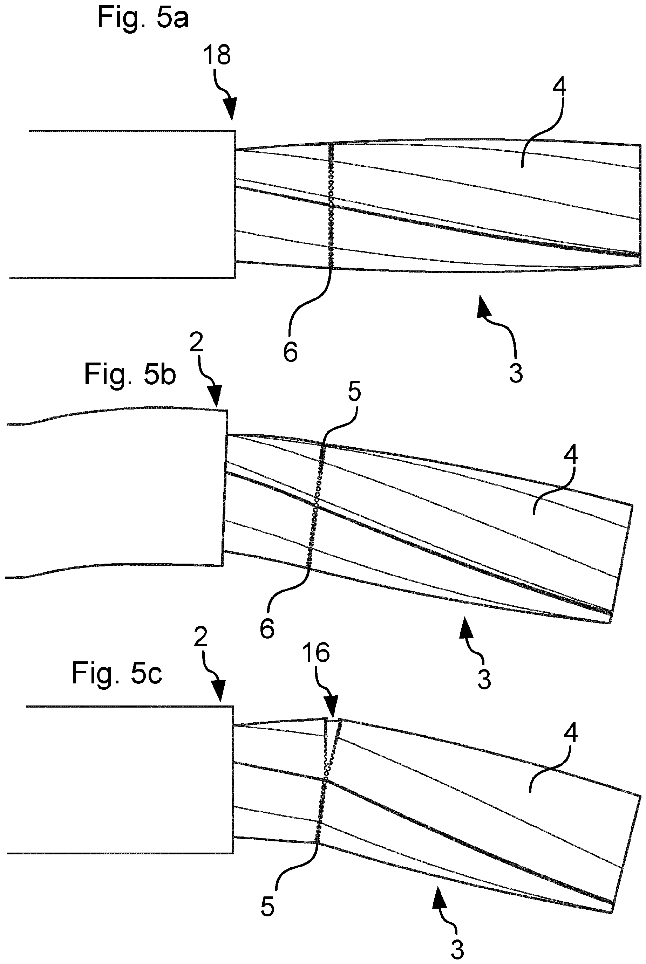

Fig. 5a zeigt eine Seitenansicht des Mantelleitungskabels 2 aus Fig. 2 vor einem Biegen. Fig. 5b zeigt eine Seitenansicht des Mantelleitungskabels 2 aus Fig. 5a während des Biegens vor dem Reißen der Schirmfolie 4 an einer Sollbruchstelle 5. Fig. 5c zeigt eine Seitenansicht des Mantelleitungskabels 2 aus Fig. 5a bzw. Fig. 5b während des Biegens nach dem Reißen der Schirmfolie 4 über einen Teil des Umfangs der Schirmfolie 4.

Die Sollbruchstelle 5 ist ein Bereich, der sich im Wesentlichen entlang einer Umfangsrichtung (in Fig. 5a in die Zeichenebene hinein bzw. aus der Zeichenebene heraus) erstreckt. An der Sollbruchstelle 5 ist die Schirmfolie 4 perforiert oder auf eine andere Art und Weise gezielt geschwächt. Das Mantelleitungskabel 2 bzw. die Schirmfolie 4 wird in einem ersten Teil der Schirmfolie 4 von dem Biegegreifer 10 ergriffen und zumindest teilweise senkrecht zur Längsrichtung des Mantelleitungskabels 2, die in Fig. 5a von links nach rechts verläuft, bewegt und dadurch gebogen. Ein Teilbereich des Mantelleitungskabels 2 wird folglich gebogen, indem ein Teil des Teilbereichs des Mantelleitungskabels 2 senkrecht zu der Richtung, die in Fig. 5a von links nach rechts verläuft, bewegt wird. Die Situation während des Biegens des Mantelleitungskabels 2 vor dem Reißen der Schirmfolie 4 an der Sollbruchstelle 5 ist in Fig. 5b zu sehen.

Vorstellbar ist auch, dass das Mantelleitungskabel 2 (manuell) gebogen wird und in der gebogenen Form anschließend von dem Biegegreifer 10 ergriffen bzw. gehalten wird. Hierbei wird das Mantelleitungskabel 2 nicht in einem nicht-gekippten Zustand ergriffen und dann gebogen, sondern der Biegegreifer 10 befindet sich beispielsweise bereits auf der elliptischen Bahn, entlang derer der erste Teil des Mantelleitungskabels 2 anschließend bewegt wird. Der erste Teil des Mantelleitungskabels 2 wird entsprechend manuell bewegt und anschließend von dem Biegegreifer 10 gehalten.

Das Mantelleitungskabel 2 wird weiter gebogen, bis ein Riss 16 auf einem Teil des Umfangs der Schirmfolie 4 entstanden ist. Dies ist in Fig. 5c gezeigt. Nun wird das Mantelleitungskabel 2 nicht weiter in die bisherige Richtung gebogen, d.h. der Biegewinkel wird nicht weiter erhöht.

Anschließend wird ein erster Teil des Mantelleitungskabels 2, der von dem Biegegreifer 10 ergriffen wurde, sowie ein Teil des Mantelleitungskabels 2, der einen größeren Abstand zu der Sollbruchstelle 5 als zu dem Biegegreifer 10 aufweist, in einer ellipsenförmigen Bewegung bewegt. Anders ausgedrückt wird der erste Teil des Mantelleitungskabels 2, der von dem Biegegreifer 10 ergriffen wurde bzw. gehalten wird, und der Bereich bzw. Teil des Mantelleitungskabels 2, der sich zwischen dem Biegegreifer 10 und dem Zusatzgreifer 12 bzw. dem Transportschlitten befindet, in einer ellipsenförmigen Bewegung bewegt. Kein Teil des Mantelleitungskabels 2 oder der Schirmfolie 4 wird hierbei gegenüber dem Rest des Mantelleitungskabels 2 verdreht.

Die ellipsenförmige Bewegung kann eine kreisförmige Bewegung sein. Der Winkel, in dem das Mantelleitungskabel 2 gebogen ist, kann während der ellipsenförmigen Bewegung geändert werden. Dies ist insbesondere für Mantelleitungskabel 2 mit einem länglichen und/oder asymmetrischen Querschnitt effektiv, da hierdurch sichergestellt ist, dass stets eine ausreichende Zugspannung zum Reißen der Schirmfolie 4 in der Sollbruchstelle 5 vorhanden ist und gleichzeitig das Mantelleitungskabel 2 nicht unbeabsichtigt beschädigt wird.

Durch die Drehung des ersten Teils des Mantelleitungskabels 2 mittels des Biegegreifers 10 bewegt sich die Reißspannung bzw. die Zugspannung über den gesamten Umfang der Schirmfolie 4. Die Schirmfolie 4 reißt nach und nach über den gesamten Umfang der Schirmfolie 4 bzw. des Mantelleitungskabels 2.

Der Beigegreifer 10 wird zum Abstreifen bzw. Entfernen der Schirmfolie 4 von dem Mantelleitungskabel 2 verwendet.

Nach dem Abreißen des von dem Biegegreifer 10 gehaltenen Teils der Schirmfolie 4 und dem Entfernen der Schirmfolie 4 von dem Mantelleitungskabel 2 kann der Biegegreifer 10 den Teil der Schirmfolie 4 loslassen. Durch Luftdruck wird die Schirmfolie 4 von dem Biegegreifer 10 bzw. den Greifflächen 11 des Biegegreifers 10 gelöst und kann anschließend mittels einer Absaugdüse 19 abgesaugt werden.

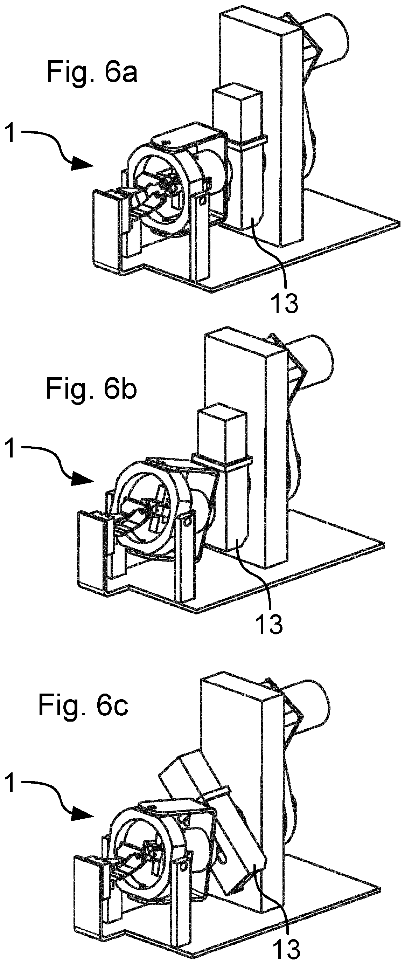

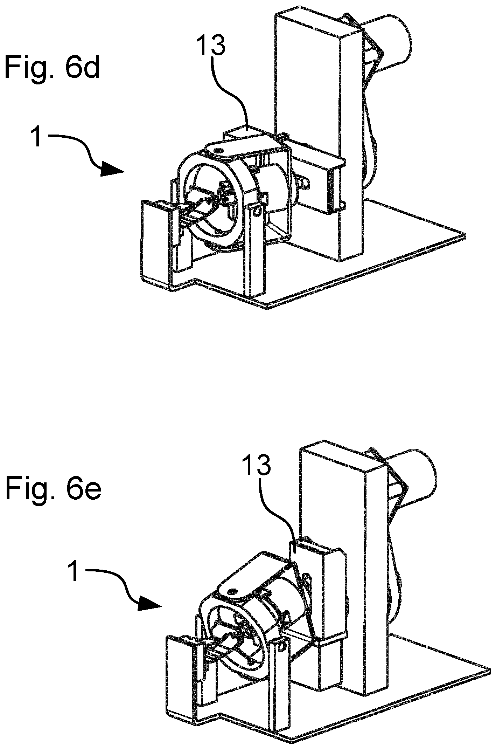

Fig. 6a-6e zeigen den Ablauf des Verfahrens, wobei das Mantelleitungskabel 2 in den Zeichnungen nicht gezeigt bzw. zu sehen ist. Fig. 6a zeigt die Folienentfernungsvorrichtung 1 aus Fig. 1 mit dem Biegegreifer 10 in einer Grundposition ohne ein Mantelleitungskabel 2. Der erste Teil des Mantelleitungskabels 2 wird in der Grundposition des Biegegreifers 10 entlang einer Längsrichtung gehalten, der in Richtung der Längsrichtung des übrigen Mantelleitungskabels 2 verläuft. Fig. 6b zeigt die Folienentfernungsvorrichtung 1 aus Fig. 6a, nach dem Drehen des Biegegreifers 10 aus der Grundposition um die Achse 9'. Fig. 6c zeigt die Folienentfernungsvorrichtung 1 aus Fig. 6a bzw. Fig. 6b nach dem Drehen bzw. Taumeln des Biegegreifers 10. Fig. 6d zeigt die Folienentfernungsvorrichtung 1 aus Fig. 6a bzw. Fig. 6b bzw. Fig. 6c nach einem weiteren Drehen bzw. Taumeln des Biegegreifers 10. Fig. 6e zeigt die Folienentfernungsvorrichtung 1 aus Fig. 6a bzw. Fig. 6b bzw. Fig. 6c bzw. Fig. 6d nach einem weiteren Drehen bzw. Taumeln des Biegegreifers 10.

Das Drehen bzw. Taumeln des Biegegreifers 10 wird durch Drehung bzw. Bewegung der Exzentereinrichtung 13 mittels eines Motors 15 ausgeführt.

Der Biegegreifer 10 befindet sich zunächst in einer Grundposition, wie dies in Fig. 6a gezeigt ist. Die Ausdehnungsrichtung des Mantelleitungskabels 2 ist an der Stelle des Zusatzgreifers 12 die gleiche wie auf der der Sollbruchstelle 5 abgewandten Seite des Biegegreifers 10.

Zunächst wird das Mantelleitungskabel 2 mit der Schirmfolie 4, die eine Sollbruchstelle 5 aufweist, derart angeordnet, dass die Sollbruchstelle 5 zwischen dem Biegegreifer 10 und dem Zusatzgreifer 12 angeordnet ist. Wenn kein Zusatzgreifer 12 vorhanden ist, wird ein Teil des Mantelleitungskabels 2 von einem Transportschlitten gehalten. Der Transportschlitten kann das Mantelleitungskabel 2 zu der Folienentfernungsvorrichtung 1 hin und nach dem Entfernen eines Teils der Schirmfolie 4 von der Folienentfernungsvorrichtung 1 weg transportieren.

Die Sollbruchstelle 5 der Schirmfolie 4 wird an dem Schnittpunkt der Achsen 9, 9' der kardanischen Aufhängung 8 angeordnet. Dies bedeutet, dass das Mantelleitungskabel 2 derart angeordnet wird, dass die Mittelachse des Mantelleitungskabels 2 auf der Höhe der in Fig. 4 von hinten nach vorne durch die Zeichnungsebene verlaufenden Achse 9' der kardanischen Aufhängung 8 verläuft und die Sollbruchstelle 5 in der Richtung von links nach rechts in Fig. 4 auf Höhe der von in Fig. 4 von oben nach unten verlaufenden Achse 9 der kardanischen Aufhängung 8 angeordnet ist.

Die Greifbacken werden aufeinander zu bewegt, um das Mantelleitungskabel 2 zu greifen bzw. einen Teil des Mantelleitungskabels 2, an dem die Schirmfolie 4 offenliegt.

Nun wird das Kugelgelenk, das den Biegegreifer 10 mit der Exzentereinrichtung 13 verbindet, bewegt, nämlich in Fig. 6b nach unten. Dies führt zu einer Drehung des Biegegreifers 10. Hierdurch wird ein Teil des Mantelleitungskabels 2 nach unten gebogen. Die Auslenkung bzw. die Winkelstellung des Biegegreifers 10 ist so groß, dass die Schirmfolie 4 an der Sollbruchstelle 5 aufgrund der erzeugten Zugspannung auf einem Teil des Umfangs der Schirmfolie 4 bzw. des Mantelleitungskabels 2 reißt, nämlich auf der oberen Seite der Schirmfolie 4, da ein Teil des Mantelleitungskabels 2 nach unten gebogen wird.

Der Biegegreifer 10 wird um den Drehpunkt der kardanischen Aufhängung 8 gedreht. Der Winkel kann z.B. in einem Bereich von ca. 10° bis ca. 30°, insbesondere ca. 15° bis ca. 25° liegen. Beispielsweise kann der Winkel ca. 17° bis ca. 20°, insbesondere ca. 18°, sein.

Anschließend wird die Exzentereinrichtung 13 und somit auch der Biegegreifer 10 mittels eines Motors 15 gedreht, und zwar um den Drehpunkt der kardanischen Aufhängung 8. Die Position des Mantelleitungskabels 2 an der Sollbruchstelle 5 bleibt im Wesentlichen unverändert. Der Teil des Mantelleitungskabels 2, der der Sollbruchstelle 5 unmittelbar benachbart ist und dem Zusatzgreifer 12 abgewandt ist, wird auf einer ellipsenförmigen Bahn bewegt.

In Fig. 6b-Fig. 6e wird der Biegegreifer 10 in einem Drehsinn gedreht, die in einer Richtung gesehen, die von dem Zusatzgreifer 12 zu dem Biegegreifer 10 verläuft, entgegengesetzt zu dem Uhrzeigersinn ist.

Durch die Drehung des Biegegreifers 10 und die daraus folgende Biegung eines Teilbereichs des Mantelleitungskabels 2 in verschiedene Richtungen bewegt sich die Zugspannung über den gesamten Umfang der Schirmfolie 4, so dass sich der Riss 16 entlang der Sollbruchstelle 5 über den Umfang der Schirmfolie 4 bewegt, bis schließlich die von dem Biegegreifer 10 gehaltene Teil der Schirmfolie 4 vollständig von dem Mantelleitungskabel 2 (das von dem Zusatzgreifer 12 gehalten wird) abgerissen ist.

Das Mantelleitungskabel 2 wird von dem Zusatzgreifer 12 losgelassen und mittels des Schlittens wegbewegt. Das Mantelleitungskabel 2 wird somit von der Folienentfernungsvorrichtung 1 entfernt, so dass der Beigegreifer den abgetrennten Teil der Schirmfolie 4 zurückhält und von dem Mantelleitungskabel 2 örtlich trennt.

Nun öffnet sich der Biegegreifer 10, um den abgetrennten Teil der Schirmfolie 4 nicht länger festzuhalten.

Nun kann Druckluft durch Druckluftkanäle 18, 18' der Greifbacken bzw. Ausblasöffnung des Biegegreifers 10 geblasen werden, wodurch der von dem Mantelleitungskabel 2 getrennte Teil der Schirmfolie 4 von den Greifbacken gelöst bzw. weg bewegt wird.

Anschließend wird durch eine Absaugdüse 19 und einen Absaugschlauch 20 der abgetrennte Teil der Schirmfolie 4 abgesaugt.

Nun ist die Folienentfernungsvorrichtung 1 zum Entfernen eines Teils der Schirmfolie 4 eines weiteren Mantelleitungskabels 2 bereit.

Der Biegegreifer 10 kann soweit um den Drehpunkt der kardanischen Aufhängung 8 gedreht werden, dass er eine Drehung um ca. 360° durchführt. Auch ist es, um ein Reißen über den gesamten Umfang der Schirmfolie 4 besonders sicherzustellen, vorstellbar, dass der Biegegreifer 10 um ca. 720° gedreht wird.

Der Drehsinn der Drehung des Biegegreifers 10 kann abhängig von einer Wickelrichtung 17 der Schirmfolie 4 sein. Die Schirmfolie 4 weist üblicherweise einen Überlappungsbereich 7 auf. In dem Überlappungsbereich 7 weist die Schirmfolie 4 zwei Schichten auf: eine in Bezug auf die Radialrichtung des Mantelleitungskabels 2 äußere Schicht und eine in Bezug auf die Radialrichtung des Mantelleitungskabels 2 innere Schicht.

In Fig. 3a weist die Schirmfolie 4 eine Wickelrichtung 17 entgegengesetzt zum Uhrzeigersinn auf. In Fig. 3b weist die Schirmfolie 4 eine Wickelrichtung 17 in Uhrzeigerrichtung auf.

Der Drehsinn bzw. die Drehsinnrichtung der Drehung des Biegegreifers 10 ist bevorzugt entgegengesetzt zur der Wickelrichtung 17 der Schirmfolie 4, so dass der Riss 16 an der Sollbruchstelle 5 in den in Radialrichtung unteren Teil der Schirmfolie 4 geleitet wird. Bei einem Drehsinn der Drehung des Biegegreifers 10 in Richtung der Wickelrichtung 17 der Schirmfolie 4 kann unter ungünstigen Umständen ein zweiter Riss 16 entstehen und folglich die Gefahr einer Fähnchenbildung, insbesondere am Treffpunkt beider Risse, stark erhöht sein. Dies gilt insbesondere, wenn der untere Teil der Schirmfolie 4 eine geringere bzw. schlechtere Perforation 6 aufweist als der obere Teil der Schirmfolie 4 im Überlappungsbereich 7.

In dem Überlappungsbereich 7 kann der in Radialrichtung äußere Teil der Schirmfolie 4 mit einer Schlitzperforierung versehen sein bzw. werden und der in Radialrichtung innere Teil der Schirmfolie 4 kann mit einer Lochperforation versehen sein bzw. werden. Die Schlitzperforierung kann einen langen Schlitz über die gesamte Länge des Überlappungsbereichs 7 entlang der Umfangsrichtung der Schirmfolie 4 umfassen bzw. sein.

Der Zusatzgreifer 12 kann als Prismengreifer ausgestaltet sein. Hierdurch weist der Zusatzgreifer 12 einen vergrößerten Fangbereich auf, in der das Kabel durch den Zusatzgreifer 12 ergriffen werden kann. Zudem wird hierdurch eine höhere Positioniergenauigkeit erreicht.

Vorstellbar ist auch, dass ein Biegegreifer 10 auf einer Exzentereinrichtung 13 angeordnet ist, d.h. das Kabel wird manuell gebogen, in dem Biegegreifer 10 befestigt und anschließend wird der Biegegreifer 10 auf einer ellipsenförmigen Bewegung, insbesondere einer kreisförmigen Bewegung, bewegt.

Wenn das Mantelleitungskabel 2 empfindlich, insbesondere empfindlich hinsichtlich Biegens ist, kann die Sollbruchstelle 5 mit einer Zugspannung beaufschlagt werden, bevor eine Biegung eines Teilbereichs des Mantelleitungskabels 2 durchgeführt wird. Somit kann der Biegewinkel verringert werden.

## Patentansprüche

1. Verfahren zum Entfernen eines Teils einer Schirmfolie (4) eines Mantelleitungskabels (2), wobei das Mantelleitungskabels (2) einen ersten Teil und einen zweiten Teil umfasst, wobei der zweite Teil ergriffen ist,
wobei das Verfahren folgende Schritte umfasst:
Bereitstellen des Mantelleitungskabels (2) mit der Schirmfolie (4), wobei die Schirmfolie (4) eine im Wesentlichen entlang eines Umfangs der Schirmfolie (4) verlaufende Sollbruchstelle (5) aufweist;
Biegen eines Teilbereichs des Mantelleitungskabels (2) mit der Schirmfolie (4) in eine erste Richtung zum Erzeugen einer derartigen Reißspannung an der Sollbruchstelle (5) auf einem Teil des Umfangs der Schirmfolie (4), dass die Schirmfolie (4) an der Sollbruchstelle (5) auf einem Teil des Umfangs der Schirmfolie (4) reißt;
Bewegen eines ersten Teils des Mantelleitungskabels (2) in einer im Wesentlichen ellipsenförmigen, insbesondere kreisförmigen, Bewegung zum Erzeugen einer Reißspannung über im Wesentlichen den gesamten Umfang der Schirmfolie (4), so dass die Schirmfolie (4) an der Sollbruchstelle (5) über den gesamten Umfang der Schirmfolie (4) reißt; und
Entfernen des von dem Mantelleitungskabel (2) getrennten Teils der Schirmfolie (4) von dem Mantelleitungskabel (2).

2. Verfahren nach Anspruch 1, wobei
das Bewegen des ersten Teils des Mantelleitungskabels (2) in einer elliptischen, insbesondere kreisförmigen, Bewegung in einem Drehsinn ausgeführt wird, die entgegengesetzt zu einer Wickelrichtung (17) der Schirmfolie (4) entlang eines Umfangs des Mantelleitungskabels (2) ist.

3. Verfahren nach Anspruch 1 oder 2, wobei
vor dem Schritt des Bewegens des ersten Teils des Mantelleitungskabels (2) in einer elliptischen Bewegung die Schirmfolie (4) in die Längsrichtung des Mantelleitungskabels (2) vorgespannt wird.

4. Verfahren nach einem der vorhergehenden Ansprüche, wobei
eine Länge eines Biegebereichs, in dem das Mantelleitungskabel (2) durch die elliptische Bewegung des ersten Teils des Mantelleitungskabels (2) gebogen wird, und/oder ein Biegewinkel, in dem das Mantelleitungskabel (2) durch die elliptische Bewegung des ersten Teils des Mantelleitungskabels (2) gebogen wird, auf die Eigenschaften des Mantelleitungskabels (2) angepasst wird.

5. Verfahren nach einem der vorhergehenden Ansprüche, ferner folgenden Schritt umfassend:
Lösen der von dem Mantelleitungskabel (2) an der Sollbruchstelle (5) abgetrennten Schirmfolie (4) von einem Biegegreifer (10), der den von dem Mantelleitungskabel (2) abgetrennten Teil der Schirmfolie (4) hält, mittels Druckluft und/oder Absaugen der abgetrennten Schirmfolie (4).

6. Verfahren nach einem der vorhergehenden Ansprüche, wobei der zweite Teil des Mantelleitungskabels (2) derart ergriffen ist, dass sich die Sollbruchstelle (5) zwischen dem ersten Teil des Mantelleitungskabels (2) und dem zweiten Teil des Mantelleitungskabels (2) befindet.

7. Verfahren nach einem der vorhergehenden Ansprüche, wobei
der erste Teil des Mantelleitungskabels (2) mittels einer kardanischen Aufhängung (8) in einer ellipsenförmigen Bewegung bewegt wird.

8. Verfahren nach Anspruch 7, wobei
der erste Teil des Mantelleitungskabels (2) mittels der kardanischen Aufhängung (8) in einer ellipsenförmigen Bewegung derart bewegt wird, dass sich auf einer Ebene, in der die Sollbruchstelle (5) der Schirmfolie (4) verläuft, der Drehpunkt der kardanischen Aufhängung (8) befindet.

9. Verfahren nach einem der vorhergehenden Ansprüche, ferner folgenden Schritt umfassend:
Erzeugen der Sollbruchstelle (5) der Schirmfolie (4) durch Loch- und/oder Schlitzperforieren der Schirmfolie (4) entlang des Umfangs der Schirmfolie (4).

10. Verfahren nach Anspruch 9, wobei
in einem Überlappungsbereich (7) der Schirmfolie (4), in dem die Schirmfolie (4) entlang eines Umfangs des Mantelleitungskabels (2) überlappend angeordnet ist, ein in Radialrichtung des Mantelleitungskabels (2) äußerer Teil der Schirmfolie (4) an der Sollbruchstelle (5) schlitzperforiert wird und ein in Radialrichtung des Mantelleitungskabels (2) innerer Teil der Schirmfolie (4) an der Sollbruchstelle (5) lochperforiert wird.

11. Folienentfernungsvorrichtung (1) zum Entfernen eines Teils einer Schirmfolie (4) eines Mantelleitungskabels (2) an einer Sollbruchstelle (5) von dem Mantelleitungskabel (2), wobei die Entfernungsvorrichtung folgendes aufweist:
- einen Biegegreifer (10) zum Greifen eines ersten Teils des Mantelleitungskabels (2) und zum Halten des ergriffenen ersten Teils des Mantelleitungskabels (2) derart, dass das Mantelleitungskabel (2) sich zumindest teilweise in einem gebogenen Zustand befindet, so dass eine derartige Reißspannung an der Sollbruchstelle (5) auf einem Teil des Umfangs der Schirmfolie (4) erzeugt wird, dass die Schirmfolie (4) an der Sollbruchstelle (5) auf einem Teil des Umfangs der Schirmfolie (4) reißt; und
- eine Drehvorrichtung zum Bewegen des Biegegreifers (10) derart, dass der erste Teil des Mantelleitungskabels (2) entlang einer elliptischen, insbesondere kreisförmigen, Bahn zum Erzeugen einer Reißspannung über im Wesentlichen den gesamten Umfang der Schirmfolie (4) bewegt wird, so dass die Schirmfolie (4) an der Sollbruchstelle (5) über den gesamten Umfang der Schirmfolie (4) reißt.

12. Folienentfernungsvorrichtung (1) nach Anspruch 11, ferner umfassend einen Zusatzgreifer (12) zum Ergreifen eines zweiten Teils des Mantelleitungskabels (2) derart, dass sich die Sollbruchstelle (5) zwischen dem Zusatzgreifer (12) und dem Biegegreifer (10) befindet.

13. Folienentfernungsvorrichtung (1) nach Anspruch 11 oder 12, ferner umfassend:
eine oder mehrere Ausblasöffnungen in dem Biegegreifer (10) zum Ausblasen eines Fluids zum Lösen der Schirmfolie (4) von dem Biegegreifer (10) und/oder
eine Absaugvorrichtung zum Absaugen der von dem Mantelleitungskabel (2) getrennten Schirmfolie (4).

14. Folienentfernungsvorrichtung (1) nach einem der Ansprüche 11-13, wobei
der Biegegreifer (10) eine sich von der Sollbruchstelle (5) weg verbreiternde kegelstumpfförmige Aussparung, insbesondere eine kegelstumpfartige Aussparung mit einem Öffnungswinkel der Aussparung von kleiner gleich ca. 4°, aufweist.

15. Folienentfernungsvorrichtung (1) nach einem der Ansprüche 11-14, wobei
die Drehvorrichtung derart ausgebildet ist, dass ein Drehsinn des ersten Teils des Mantelleitungskabels (2) bei dem Bewegen des ersten Teils des Mantelleitungskabels (2) entlang einer elliptischen, insbesondere kreisförmigen, Bahn, auf eine Wickelrichtung (17) der Schirmfolie (4) entlang eines Umfangs des Mantelleitungskabels (2), abstimmbar ist.

## Claims

1. Method for removing part of a shielding foil (4) of a sheathed cable (2), wherein the sheathed cable (2) comprises a first part and a second part, wherein the second part is gripped, wherein the method comprises the following steps:
providing the sheathed cable (2) with the shielding foil (4), wherein the shielding foil (4) comprises a predetermined breaking point (5) that extends substantially along a circumference of the shielding foil (4);
bending a portion of the sheathed cable (2) with the shielding foil (4) in a first direction in order to create such a tearing tension at the predetermined breaking point (5) on a part of the circumference of the shielding foil (4) that the shielding foil (4) tears at the predetermined breaking point (5) on a part of the circumference of the shielding foil (4);
moving a first part of the sheathed cable (2) in a substantially elliptical, in particular circular, movement in order to create a tearing tension over substantially the entire circumference of the shielding foil (4), so that the shielding foil (4) tears at the predetermined breaking point (5) over the entire circumference of the shielding foil (4); and
removing from the sheathed cable (2) the part of the shielding foil (4) that was stripped from the sheathed cable (2).

2. Method according to claim 1, wherein
the first part of the sheathed cable (2) is moved in an elliptical, in particular circular, movement in a direction of rotation which is opposite to a winding direction (17) of the shielding foil (4) along a circumference of the sheathed cable (2).

3. Method according to claim 1 or 2, wherein
before the step in which the first part of the sheathed cable (2) is moved in an elliptical movement, the shielding foil (4) is prestressed in the longitudinal direction of the sheathed cable (2).

4. Method according to any of the preceding claims, wherein
a length of a bending region in which the sheathed cable (2) is bent by the elliptical movement of the first part of the sheathed cable (2) and/or a bending angle in which the sheathed cable (2) is bent by the elliptical movement of the first part of the sheathed cable (2) is adapted to the characteristics of the sheathed cable (2).

5. Method according to any of the preceding claims, furthermore comprising the following step:
removing the shielding foil (4) stripped from the sheathed cable (2) at the predetermined breaking point (5) from a bending gripper (10) that holds the part of the shielding foil (4) that was stripped from the sheathed cable (2) by means of pressurized air and/or suctioning of the stripped shielding foil (4).

6. Method according to any of the preceding claims, wherein
the second part of the sheathed cable (2) is gripped in such a way that the predetermined breaking point (5) is located between the first part of the sheathed cable (2) and the second part of the sheathed cable (2).

7. Method according to any of the preceding claims, wherein
the first part of the sheathed cable (2) is moved by means of a gimbal (8) in an elliptical movement.

8. Method according to claim 7, wherein
the first part of the sheathed cable (2) is moved by means of the gimbal (8) in an elliptical movement in such a way that the center of rotation of the gimbal (8) is located on a level on which the predetermined breaking point (5) of the shielding foil (4) extends.

9. Method according to any of the preceding claims, furthermore comprising the following step:
creating the predetermined breaking point (5) of the shielding foil (4) by means of perforated holes and/or slits in the shielding foil (4) along the circumference of the shielding foil (4).

10. Method according to claim 9, wherein
in an overlapping region (7) of the shielding foil (4), in which the shielding foil (4) is arranged along a circumference of the sheathed cable (2) in an overlapping manner, an outer part of the shielding foil (4) in the radial direction of the sheathed cable (2) is slit-perforated at the predetermined breaking point (5) and an inner part of the shielding foil (4) in the radial direction of the sheathed cable (2) is hole-perforated at the predetermined breaking point (5).

11. Foil removal device (1) for removing a part of a shielding foil (4) of a sheathed cable (2) from the sheathed cable (2) at a predetermined breaking point (5), wherein the removal device comprises the following:
- a bending gripper (10) for gripping a first part of the sheathed cable (2) and for holding the gripped first part of the sheathed cable (2) in such a way that the sheathed cable (2) is at least partially in a bent state, so that such a tearing tension is created at the predetermined breaking point (5) on a part of the circumference of the shielding foil (4) that the shielding foil (4) tears at the predetermined breaking point (5) on a part of the circumference of the shielding foil (4); and
- a rotational device for moving the bending gripper (10) in such a way that the first part of the sheathed cable (2) is moved along an elliptical, in particular circular, path in order to create a tearing tension over substantially the entire circumference of the shielding foil (4), so that the shielding foil (4) tears at the predetermined breaking point (5) over the entire circumference of the shielding foil (4).

12. Foil removal device (1) according to claim 11, further comprising an additional gripper (12) for gripping a second part of the sheathed cable (2) in such a way that the predetermined breaking point (5) is located between the additional gripper (12) and the bending gripper (10).

13. Foil removal device (1) according to claim 11 or 12, further comprising: one or more blow-out openings in the bending gripper (10) for blowing out a fluid used to remove the shielding foil (4) from the bending gripper (10) and/or
a suction device for suctioning the shielding foil (4) stripped from the sheathed cable (2).

14. Foil removal device (1) according to any of claims 11-13, wherein the bending gripper (10) comprises a frusto-conical recess that widens in the direction away from the predetermined breaking point (5), in particular a frusto-conical recess with an opening angle of the recess of less than or equal to approximately 4°.

15. Foil removal device (1) according to any of claims 11-14, wherein the rotational device is formed in such a way that a direction of rotation of the first part of the sheathed cable (2), when the first part of the sheathed cable (2) is moved along an elliptical, in particular circular, path, can be matched to a winding direction (17) of the shielding foil (4) along a circumference of the sheathed cable (2).

## Revendications

1. Procédé permettant le retrait d'une partie d'un film de blindage (4) d'un câble gainé (2), le câble gainé (2) comprenant une première partie et une seconde partie, la seconde partie étant saisie, le procédé comprenant les étapes suivantes :
fourniture du câble gainé (2) comportant le film de blindage (4), le film de blindage (4) présentant un point de rupture cible (5) s'étendant sensiblement le long d'une circonférence du film de blindage (4) ;
pliage d'une partie du câble gainé (2) comportant le film de blindage (4) dans une première direction pour générer une contrainte de déchirement au niveau du point de rupture cible (5) sur une partie de la circonférence du film de blindage (4) tel que le film de blindage (4) se déchire au niveau du point de rupture cible (5) sur une partie de la circonférence du film de blindage (4) ;
déplacement d'une première partie du câble gainé (2) selon un mouvement sensiblement elliptique, en particulier circulaire, pour générer une contrainte de déchirement sur sensiblement toute la circonférence du film de blindage (4), de sorte que le film de blindage (4) se déchire au niveau du point de rupture cible (5) sur toute la circonférence du film de blindage (4) ; et
retrait de la partie du film de blindage (4) séparée du câble gainé (2) du câble gainé (2).

2. Procédé selon la revendication 1, dans lequel
le déplacement de la première partie du câble gainé (2) selon un mouvement elliptique, en particulier circulaire, est réalisé dans un sens de rotation opposé à un sens d'enroulement (17) du film de blindage (4) le long d'une circonférence du câble gainé (2).

3. Procédé selon la revendication 1 ou 2, dans lequel,
avant l'étape de déplacement de la première partie du câble gainé (2) selon un mouvement elliptique, le film de blindage (4) est précontraint dans le sens longitudinal du câble gainé (2).

4. Procédé selon l'une des revendications précédentes, dans lequel
une longueur d'une zone de pliage dans laquelle le câble gainé (2) est plié par le mouvement elliptique de la première partie du câble gainé (2), et/ou un angle de pliage dans lequel le câble gainé (2) est plié par le mouvement elliptique de la première partie du câble gainé (2), sont adaptés aux propriétés du câble gainé (2).

5. Procédé selon l'une des revendications précédentes, comprenant en outre l'étape suivante :
détachement du film de blindage (4) séparé du câble gainé (2) au niveau du point de rupture cible (5) d'une pince de pliage (10) qui maintient la partie du film de blindage (4) séparée du câble gainé (2), au moyen d'air comprimé et/ou de l'aspiration du film de blindage (4) séparé.

6. Procédé selon l'une des revendications précédentes, dans lequel
la seconde partie du câble gainé (2) est saisie de telle manière que le point de rupture cible (5) est situé entre la première partie du câble gainé (2) et la seconde partie du câble gainé (2).

7. Procédé selon l'une des revendications précédentes, dans lequel
la première partie du câble gainé (2) est déplacée selon un mouvement elliptique au moyen d'une suspension à cardan (8).

8. Procédé selon la revendication 7, dans lequel
la première partie du câble gainé (2) est déplacée au moyen de la suspension à cardan (8) selon un mouvement elliptique de telle manière que le point de rotation de la suspension à cardan (8) se trouve sur un plan dans lequel s'étend le point de rupture cible (5) du film de blindage (4).

9. Procédé selon l'une des revendications précédentes, comprenant en outre l'étape suivante :
génération du point de rupture cible (5) du film de blindage (4) par perforation du film de blindage (4) avec des trous et/ou des fentes le long de la circonférence du film de blindage (4).

10. Procédé selon la revendication 9, dans lequel,
dans une zone de chevauchement (7) du film de blindage (4) dans laquelle le film de blindage (4) est disposé de manière à chevaucher le long d'une circonférence du câble gainé (2), une partie externe du film de blindage (4) dans la direction radiale du câble gainé (2) est perforée avec des fentes au niveau du point de rupture cible (5) et une partie interne du film de blindage (4) dans la direction radiale du câble gainé (2) est perforée avec des trous au niveau du point de rupture cible (5).

11. Dispositif de retrait de film (1) permettant de retirer une partie d'un film de blindage (4) d'un câble gainé (2) au niveau d'un point de rupture cible (5) du câble gainé (2), le dispositif de retrait présentant :
- une pince de pliage (10) permettant de saisir une première partie du câble gainé (2) et de maintenir la première partie saisie du câble gainé (2) de manière à ce que le câble gainé (2) se trouve au moins partiellement dans un état plié, de sorte qu'une contrainte de déchirement est générée au niveau du point de rupture cible (5) sur une partie de la circonférence du film de blindage (4) tel que le film de blindage (4) se déchire au niveau du point de rupture cible (5) sur une partie de la circonférence du film de blindage (4) ; et
- un dispositif de rotation permettant de déplacer la pince de pliage (10) de telle sorte que la première partie du câble gainé (2) est déplacée le long d'une trajectoire elliptique, en particulier circulaire, pour générer une contrainte de déchirement sur sensiblement toute la circonférence du film de blindage (4), de sorte que le film de blindage (4) se déchire au niveau du point de rupture cible (5) sur toute la circonférence du film de blindage (4).

12. Dispositif de retrait de film (1) selon la revendication 11, comprenant en outre une pince supplémentaire (12) permettant de saisir une seconde partie du câble gainé (2) de telle sorte que le point de rupture cible (5) se situe entre la pince supplémentaire (12) et la pince de pliage (10).

13. Dispositif de retrait de film (1) selon la revendication 11 ou 12, comprenant en outre : une ou plusieurs ouvertures de soufflage dans la pince de pliage (10), permettant de souffler un fluide pour détacher le film de blindage (4) de la pince de pliage (10) et/ou
un dispositif d'aspiration permettant d'aspirer le film de blindage (4) séparé du câble gainé (2).

14. Dispositif de retrait de film (1) selon l'une des revendications 11 à 13, dans lequel la pince de pliage (10) présente un évidement tronconique qui s'élargit en s'éloignant du point de rupture (5), en particulier un évidement tronconique comportant un angle d'ouverture de l'évidement inférieur ou égal à environ 4°.

15. Dispositif de retrait de film (1) selon l'une des revendications 11 à 14, dans lequel le dispositif de rotation est conçu de telle sorte qu'un sens de rotation de la première partie du câble gainé (2), lors du déplacement de la première partie du câble gainé (2) le long d'une trajectoire elliptique, en particulier circulaire, peut être accordé à un sens d'enroulement (17) du film de blindage (4) le long d'une circonférence du câble gainé (2).
